# EUROPEAN PATENT APPLICATION

(11) **EP 3 647 581 A1**
(43) Date of publication of application: **06.05.2020**
(21) Application number: 19206050.7
(22) Date of filing: 29.10.2019
(51) Int. Cl.: F02M 35/024, B60K 13/02, F02M 35/04, F02M 35/10

(54) **MULTIPLE INLET VEHICLE AIR FILTRATION SYSTEM**

(30) Priority: 29.10.2018 US 201816173870
(71) Applicant: K & N Engineering, Inc., Riverside, CA 92507 (US)
(72) Inventor: WILLIAMS, Steve, Cherry Valley, CA 92223 (US); FIELLO, Jonathan, Riverside, CA 92507 (US); HECK, Gilbert, Riverside, CA 92507 (US)
(74) Representative: Dehns

(57) **Abstract**

An air box (100) and methods are provided for communicating an airstream through an air filter (144) to an air intake duct of an internal combustion engine of a vehicle. The air box is comprised of a housing (128) that supports the air filter within an interior of the housing. A mount portion (156) within the housing fixedly receives a base of the air filter. Multiple air inlets (124) couple with corresponding air inlet ports (112) of the vehicle to direct the airstream into the air box. A duct (132) directs the airstream from the multiple air inlets to the interior of the housing and to the air filter. An opening into the housing exposes at least one surface of an electronic control unit (ECU) to the airstream for cooling of the ECU (220). A conduit (116) communicates the airstream from an interior of the air filter to the air intake duct of the internal combustion engine.

## Description

### FIELD

The field of the present disclosure generally relates to filtration devices. More particularly, the field of the present disclosure relates to an apparatus and a method for a vehicle air filtration system which exhibits an improved air flow and may be coupled with a reusable air filter so as to improve engine performance and fuel economy.

### BACKGROUND

An air filter designed to remove particulate is generally a device composed of fibrous materials. These fibrous materials may remove solid particulates such as dust, pollen, mold, and bacteria from the air. Air filters are used in applications where air quality is important, notably in building ventilation systems and with engines.

Air filters may be used in automobiles, trucks, tractors, locomotives, and other vehicles that use internal combustion engines. Air filters may be used with gasoline engines, diesel engines, or other engines that run on fossil fuels or other combustible substances. Air filters may be used with engines in which combustion is intermittent, such as four-stroke and two-stroke piston engines, as well as other types of engines that take in air so that a combustible substance may be burned. For example, air filters may be used with some gas turbines. Filters may also be used with air compressors or in other devices that take in air.

Filters may be made from pleated paper, foam, cotton, spun fiberglass, or other known filter materials. Generally, the air intakes of internal combustion engines and compressors tend to use paper, foam, or cotton filters. Some filters use an oil bath. Air filters for internal combustion engines prevent abrasive particulate matter from entering the combustion cylinders of the engine, wherein the particulate matter would cause mechanical wear and oil contamination. Many fuel injected engines utilize a flat panel, pleated paper filter element. This filter usually is placed inside an enclosed, plastic air box connected to a throttle body by way of ductwork. Vehicles that use carburetors or throttle body fuel injection systems typically use a cylindrical air filter positioned above the carburetor or the throttle body.

A drawback to conventional air boxes that require flat panel paper filters is that as particular matter builds up in the filter, air flow through the filter becomes restricted. Such a restricted air flow generally leads to a reduction in engine performance, such as a decrease in engine power output and a greater fuel consumption. Moreover, as the paper filter becomes increasingly clogged, pressure below the filter decreases while the atmospheric air pressure outside the filter remains the same. When the difference in pressure becomes too great, contaminants may be drawn through the paper filter directly into the engine. Thus, the ability of the paper filter to protect the engine from contamination and internal damage tends to decrease near the end of the filter's service life. Typically, paper air filters are removed from the vehicle and discarded, and a new paper air filter is then installed. Considering that there are millions of vehicles throughout the world, the volume of discarded air filters that could be eliminated from landfills is a staggering number.

Another drawback to conventional air boxes is that they typically direct air flow through a tortuous path of hoses or ductwork before the air enters the intake of the engine. In some cases, the air box is a greater source of air restriction than is the paper filter. Similar to a contaminated air filter, a restrictive air box decreases engine performance and fuel economy. What is needed, therefore, is an air box that exhibits improved air flow and may be coupled with a reusable air filter so as to improve engine performance and fuel economy.

### SUMMARY

An apparatus and a method are provided for an air box configured to communicate an airstream through an air filter to an air intake duct of an internal combustion engine of a vehicle. The air box is comprised of a housing that supports the air filter within an interior of the housing. A mount portion comprising the housing fixedly receives a base of the air filter. Multiple air inlets are configured to couple with corresponding air inlet ports of the vehicle to direct the airstream into the air box. A duct conveys the airstream from the multiple inlets to the air filter within the interior of the housing. An opening into the housing is configured to expose at least one surface of an electronic control unit (ECU) to the airstream. An edge portion of the opening is configured with one or more threaded holes disposed in suitable locations to receive one or more fasteners to fixedly attach the ECU to the housing, such that the surface of the ECU effectively encloses the interior of the housing. A conduit communicates the airstream from an interior of the air filter to the air intake duct of the internal combustion engine.

In an exemplary embodiment, an air box configured to communicate an airstream from one or more air inlet ports through an air filter to an air intake duct of an engine comprises a housing configured to support the air filter within an interior of the housing; one or more air inlets that are configured to receive the airstream from the one or more air inlet ports; a duct configured to direct the airstream from the one or more air inlets to the interior of the housing; an opening into the housing that is configured to expose at least one surface of an electronic control unit (ECU) to the airstream; and a conduit configured to communicate the airstream from an interior of the air filter to the air intake duct.

In another exemplary embodiment, a multiplicity of protrusions are disposed on the housing and configured to facilitate fixedly coupling the air box with the engine, the multiplicity of protrusions being configured to cooperate with any of various mounts and pads disposed within the engine bay. In another exemplary embodiment, the opening comprises an edge portion that is configured with one or more threaded holes disposed in suitable locations to receive one or more fasteners to fixedly attach the ECU to the housing, such that the at least one surface effectively encloses the interior of the housing.

In another exemplary embodiment, one or more surface features are disposed on any of the housing and the duct. In another exemplary embodiment, the one or more surface features are comprised of a groove disposed longitudinally along the duct and configured to receive a hood prop of a vehicle in which the air box is installed. In another exemplary embodiment, the one or more surface features are comprised of contoured portions that are configured to provide clearance between the air box and nearby components disposed on the engine.

In another exemplary embodiment, the one or more air inlets are configured to be blocked to the airstream so as to facilitate operation of the air box in absence of either of the one or more air inlet ports. In another exemplary embodiment, each of the one or more air inlets comprises an opening that is configured to be coupled with a corresponding one of the one or more air inlet ports, such that the airstream is passed through the one or more air inlets and into the duct. In another exemplary embodiment, a seal is disposed around a perimeter edge of each of the one or more air inlets and configured to establish a substantially air-leak resistant junction between the one or more air inlets and the one or more air inlet ports.

In another exemplary embodiment, the housing is comprised of a flat surface that is configured to receive a base of the air filter, the base being comprised of a seal that is configured to be compressed so as to establish an air-leak resistant connection between the base and the flat surface. In another exemplary embodiment, the flat surface comprises a mount portion of the housing that is configured to facilitate using one or more suitable fasteners to compress the seal between the flat surface and the base.

In an exemplary embodiment, a method for an air box to communicate an airstream from one or more air inlet ports to an air intake duct of an engine comprises supporting an air filter within an interior of a housing; configuring one or more air inlets to receive the airstream from the one or more air inlet ports; coupling the one or more air inlets with a duct to direct the airstream from the one or more inlets to the air filter; forming an opening in the housing to expose at least one surface of an electronic control unit (ECU) to the airstream; and extending a conduit from an interior of the air filter to the air intake duct.

In another exemplary embodiment, supporting comprises configuring a flat surface within the housing to receive a base of the air filter, the base being comprised of a seal that is configured to be compressed so as to establish an air-leak resistant connection between the base and the flat surface. In another exemplary embodiment, configuring the one or more air inlets comprises configuring a seal around a perimeter edge of each of the one or more air inlets to establish a substantially air-leak resistant junction between the one or more air inlets and the one or more air inlet ports. In another exemplary embodiment, forming an opening further comprises configuring an edge portion of the opening to receive one or more fasteners to fixedly attach the ECU to the housing.

### BRIEF DESCRIPTION OF THE DRAWINGS

The drawings refer to embodiments of the present disclosure in which:
Figure 1 illustrates a perspective view of an engine bay wherein an exemplary embodiment of an air box is coupled with an engine, according to the present disclosure;
Figure 2 illustrates a top view of the engine bay of Fig. 1 wherein the air box is coupled with air inlet ports disposed within the engine bay in accordance with the present disclosure;
Figure 3 illustrates an upper perspective view of an exemplary embodiment of an air box in accordance with the present disclosure;
Figure 4 illustrates a lower perspective view of the exemplary air box of Fig. 3, according to the present disclosure;
Figure 5A illustrates an upper perspective view of an exemplary embodiment of a flangeless air filter comprising a cap that encloses a top portion of a filter medium;
Figure 5B is a lower perspective view of the flangeless air filter of Fig. 5A, illustrating a base configured to be coupled with a flat mount surface within an air box of Figs. 3-4, according to the present disclosure; and
Figure 6 illustrates a lower perspective view of the air box of Fig. 4 coupled with an exemplary engine control unit (ECU) that may be air-cooled, in accordance with the present disclosure.

While the present disclosure is subject to various modifications and alternative forms, specific embodiments thereof have been shown by way of example in the drawings and will herein be described in detail. The invention should be understood to not be limited to the particular forms disclosed, but on the contrary, the intention is to cover all modifications, equivalents, and alternatives falling within the spirit and scope of the present disclosure.

### DETAILED DESCRIPTION

In the following description, numerous specific details are set forth in order to provide a thorough understanding of the present disclosure. It will be apparent, however, to one of ordinary skill in the art that the invention disclosed herein may be practiced without these specific details. In other instances, specific numeric references such as "first air inlet," may be made. However, the specific numeric reference should not be interpreted as a literal sequential order but rather interpreted that the "first air inlet" is different than a "second air inlet." Thus, the specific details set forth are merely exemplary. The specific details may be varied from and still be contemplated to be within the spirit and scope of the present disclosure. The term "coupled" is defined as meaning connected either directly to the component or indirectly to the component through another component. Further, as used herein, the terms "about," "approximately," or "substantially" for any numerical values or ranges indicate a suitable dimensional tolerance that allows the part or collection of components to function for its intended purpose as described herein.

In general, the present disclosure describes an apparatus and a method for an air box configured to communicate an airstream through an air filter to an air intake duct of an internal combustion engine of a vehicle. The air box is comprised of a housing that is configured to support the air filter within an interior of the housing. A mount portion is disposed within the housing and configured to fixedly receive a base of the air filter. Hardware fasteners may be coupled with the base of the air filter to affix the air filter to an inner surface of the mount portion, forming a leak resistant coupling there between. A conduit is configured to communicate the airstream from an interior of the air filter to the air intake duct of the internal combustion engine. One or more air inlets to the interior of the housing are configured to couple with corresponding air inlet ports of the vehicle so as to direct the airstream into the air box. A duct passes the airstream from the air inlets to the interior of the housing. An opening disposed on a bottom portion of the housing is configured to receive either a flat panel to enclose the interior of the housing or an electronic control unit (ECU) of the vehicle such that the ECU is placed into contact with the airstream and is cooled thereby.

Although embodiments of the invention may be described and illustrated herein in terms of a cone-shaped air filter, it should be understood that embodiments of this invention are not limited to the exact shape illustrated, but rather may include a wide variety of generally enclosed shapes, such as cylindrical, circular, oval, round, curved, conical, or any other closed perimeter shape, that provide a relatively large surface area in a given volume of the filter. Moreover, embodiments as described herein are not limited to use as internal combustion engine filters, but rather may have applicability in other filtration systems in which a large volume of air requires treatment.

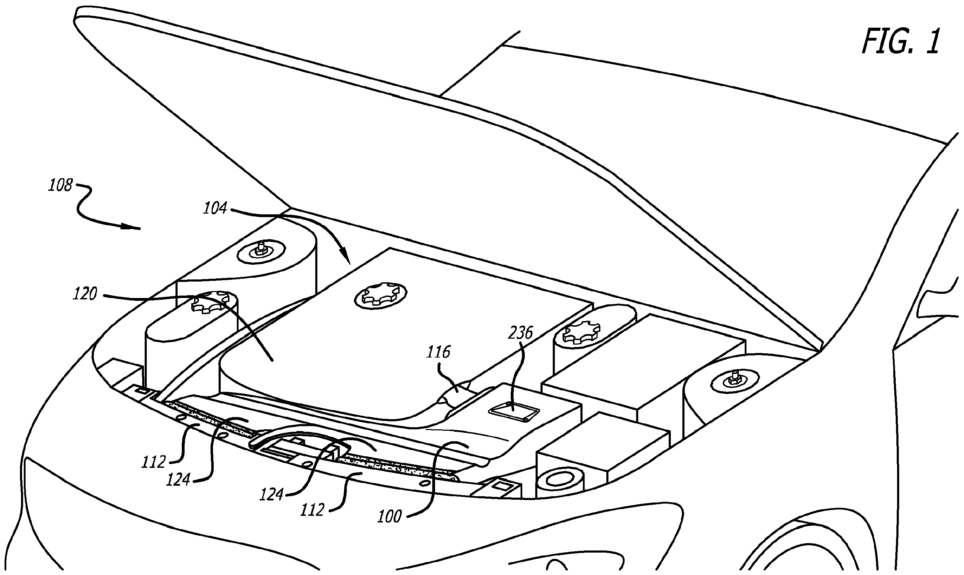

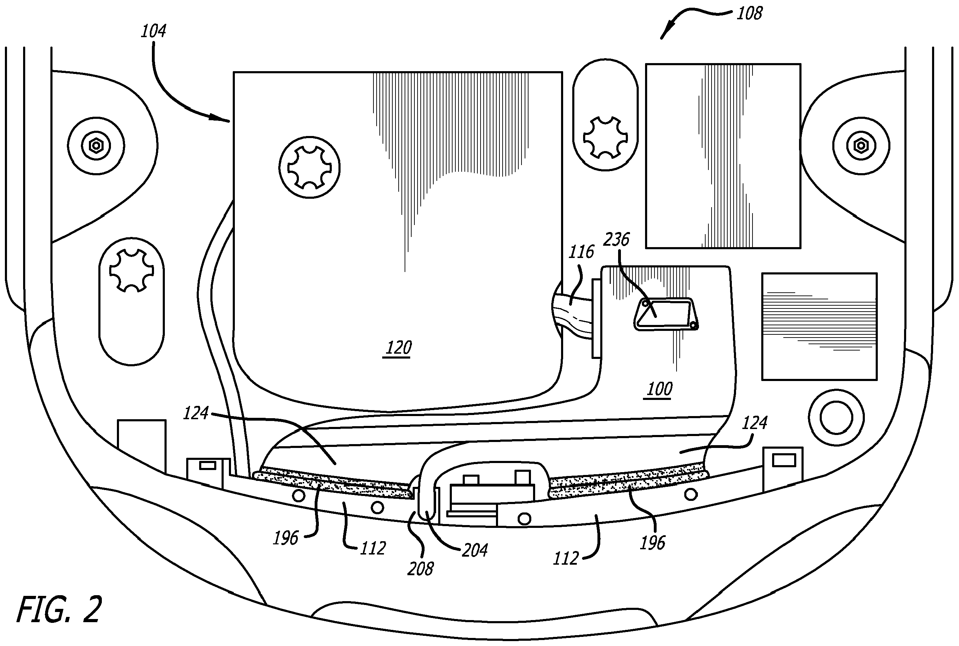

Figures 1 and 2 illustrate an exemplary embodiment of an air box 100 that is coupled with an engine 104 within an engine bay 108 of a vehicle. The air box 100 generally transports air received by way of air inlet ports 112, disposed within the engine bay 108, through a conduit 116 to an air intake duct 120 of the engine 104. As will be recognized, the air inlet ports 112 generally extend through the vehicle to a source of external air, such as a front of the vehicle. The air box 100 is comprised of air inlets 124 that are configured to receive external air by way of the air inlet ports 112.

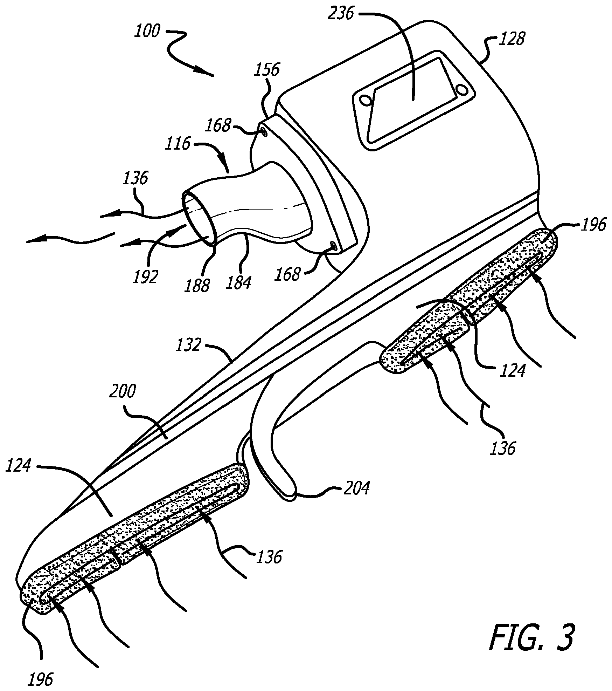

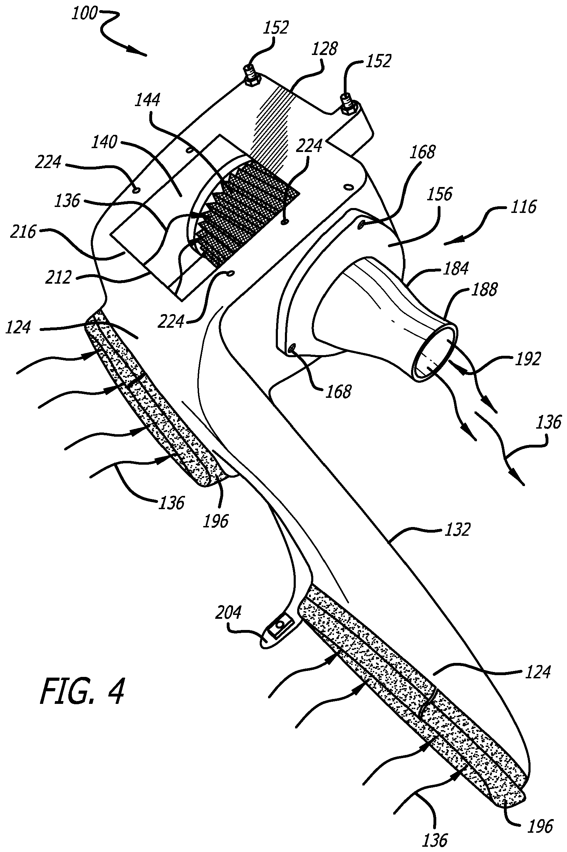

As best illustrated in Figs. 3-4, the air inlets 124 are connected to a housing 128 by way of a duct 132. The duct 132 is configured to communicate an airstream 136 entering through the air inlets 124 into an interior 140 of the housing 128. As best illustrated in Fig. 4, an air filter 144 disposed within the interior 140 is configured to remove particulate matter and contaminants that may be flowing with the airstream 136 before the airstream is directed through the conduit 116 to the air intake duct 120 of the engine 104. The air box 100 generally is of an enclosed variety and is configured to improve movement of the airstream 136 through the air filter 144 disposed within the interior 140 of the housing 128. Preferably, the interior 140 is characterized by smooth surfaces and rounded edges so as to decrease turbulence and air resistance through the air box 100, thereby improving performance of the engine 104 beyond that otherwise possible with conventional air boxes.

The housing 128 and the duct 132 preferably are comprised of a material that is sufficiently durable and temperature resistant to retain their configurations during installation and operation when coupled with the air intake duct 120 of the engine 104. In some embodiments, the housing 128 and duct 132 may be formed as a single component by way of injection molding. In some embodiments, the housing 128 and the duct 132 may be formed as separate components that may be coupled together during installation of the air box 100 into the vehicle. It is envisioned that either or both of the housing 128 and the duct 132 may be formed by way of injection molding.

In some embodiments, one or more supports may be disposed on the housing 128 and the duct 132 so as to fixate the air box 100 within the engine bay 108, as shown in Figs. 1-2. In the illustrated embodiment of Figs. 3-4, rear supports 152 are configured to be coupled with, or fastened to, mounts or supportive pads within the interior of the engine bay 108, such that the conduit 116 may be coupled with the air intake duct 120 of the engine 104. In some embodiments, the rear supports 152 may be configured to couple the air box 100 directly with the engine 104 of the vehicle. It is envisioned that the rear supports 152 may include any suitable fastening means to facilitate installing the air box 100 in the engine bay 108, such as, by way of example, suitably designed holes, brackets, molded shaped portions, protrusions, extensions, straps, hardware fasteners, or any other similar device for holding the air box 100 fixed within the engine bay 108. As will be appreciated, the particular fastening means will vary according to the specific make, model, and type of the vehicle with which the air box 100 is to be used.

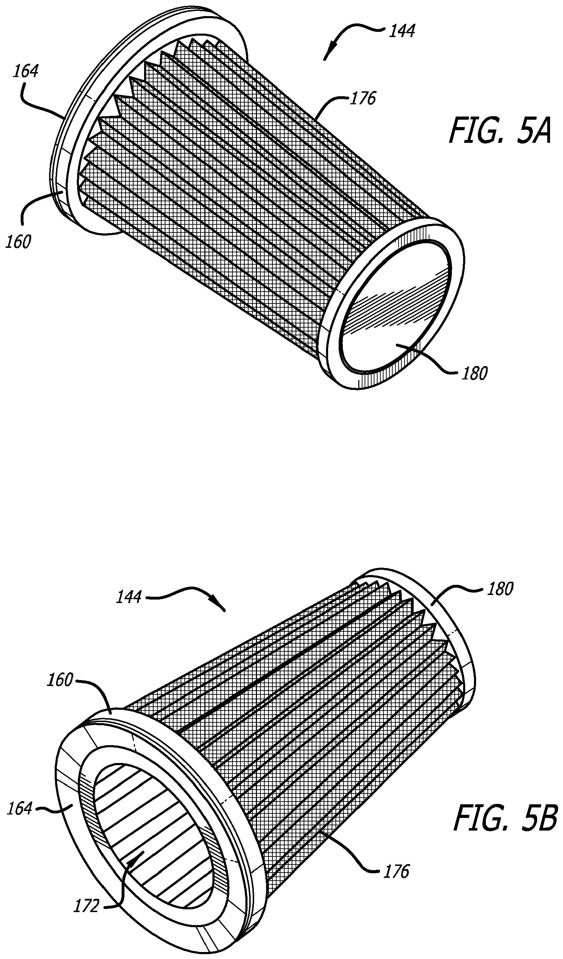

The housing 128 is configured to support the air filter 144 and provide an interface between the air filter and the air intake duct 120 of the engine 104. A front side of the housing 128 is comprised of a mount portion 156 that is configured to facilitate coupling the air filter 144 with an interior surface of the front side of the housing. In some embodiments, the air filter 144 may be of a flangeless variety, as shown in Figs. 5A-5B, and thus a base 160 of the air filter may include a compressible seal 164. In the embodiment illustrated in Figs. 3-4, the mount portion 156 is comprised of a flat surface that receives the seal 164 of the air filter 144. A multiplicity of fasteners 168, or other suitable hardware, may be used to compress the seal 164 between the base 160 of the air filter 144 and the flat surface, thereby establishing an air-leak resistant connection between an interior 172 of the air filter 144 and the mount portion 156. In some embodiments, however, the mount portion 156 may be comprised of a suitably sized flange or conduit that extends into the interior 140 and is configured to be received into an opening in the base 160 of the air filter 144. It is contemplated that the mount portion 156 may be comprised of any coupling means suitable for forming a reasonably air-leak resistant connection between the air filter 144 and the mount portion 156.

Figures 5A-5B illustrate perspective views of an exemplary embodiment of the air filter 144. The air filter 144 is of a flangeless variety that is configured for use within the air box 100. The air filter 144 is comprised of a filter medium 176 disposed between the base 160 and a cap 180. The filter medium 176 is configured to remove contaminants and particulate matter from the airstream 136 that is drawn into the air intake duct 120. In the illustrated embodiment, the filter medium 176 is a cone-shaped member having a diameter that tapers along the filter medium from the base 160 to the cap 180.

The filter medium 176 generally provides a surface area through which to pass the airstream 136 and entrap particulates and other contaminates flowing with the airstream. The filter medium 176 may be comprised of paper, foam, cotton, spun fiberglass, or other known filter materials, woven or non-woven materials, synthetic or natural, or any combination thereof. The filter medium 176 may be pleated, or otherwise shaped, or contoured so as to increase the surface area for passing the airstream 136 to be cleaned. The length of the filter medium 176 in the circumferential direction may be longer than the circular circumference of the air filter 144 generally, such that the surface area of the filter medium 176 is greater than the profile surface area of the air filter.

The cap 180 serves to direct the airstream 136 around the top-most portion of the air filter 144 and into the filter medium 176. It is contemplated that the cap 180 may be comprised of a rigid material suitable for withstanding the temperature and pressure encountered within the air box 100. The base 160 generally is configured to support the air filter 144 and provide an interface between the interior 172 of the air filter 144 and the flat surface of the mount portion 156. Any of a variety of fasteners may be used to affix the filter medium 176 to the base 160 and the cap 180. In some embodiments, the base and cap 160, 180 may be molded onto a wire support of the filter medium 176. In some embodiments, the base 160 and the cap 180 may be crimped such that they fold onto and retain the wire support and the filter medium 176 of the air filter 144. Further, the base and cap 160, 180 preferably are comprised of materials that are sufficiently hard to retain the filter medium 176 in a desired configuration and support the air filter 144 when coupled to the mount portion 156.

In some embodiments, the wire support may be incorporated into the filter medium 176. Incorporating the wire support into the filter medium 176 provides additional strength and durability to the air filter 144. For example, the filter medium 176 may be positioned between the wire support and one or more layers of a reinforcing material. The wire support may be comprised of wire screens positioned on an outer surface and an inner surface of the filter medium 176. In some embodiments, the filter medium 176 may be comprised of 4 to 6 layers of cotton gauze that are sandwiched between two epoxy-coated aluminum wire screens. It is contemplated that the wire screens may be co-pleated along with the filter medium 176 so as to reinforce the air filter 144.

In some embodiments, the cotton gauze comprising the filter medium 176 may be advantageously treated with a suitably formulated filter oil composition that causes tackiness throughout microscopic strands comprising the cotton. The nature of the cotton allows high volumes of airflow, and when combined with the tackiness of the filter oil composition creates a powerful filtering medium which ensures a high degree of air filtration. Further details about components comprising the filter medium 176, as well as details about the filter oil composition, are disclosed in U.S. Patent Application Serial No. 15/276,502, entitled "Flangeless Air Filter," filed on September 26, 2016; U.S. Patent Application Serial No. 14/181,678, entitled "Air Box With Integrated Filter Media," filed on February 16, 2014; and U.S. Patent Application Serial No. 14/701,163, entitled "Filter Oil Formulation".

With reference again to Fig. 4, the mount portion 156 places the interior 172 of the air filter 144 into fluid communication with the conduit 116. The conduit 116 is configured to convey the airstream 136 from the interior 172 of the air filter 144 to the air intake duct 120 of the engine 104. The conduit 116 is comprised of a transition 184 and a flange 188 that is configured to couple with the air intake duct 120. Preferably, the transition 184 provides a molded connection between the flange 188 and the housing 128, although other forms of connections may be apparent to those skilled in the art. In the embodiment of Fig. 4, the transition 184 generally positions a longitudinal dimension of the flange 188 at an offset with respect to a center of the mount portion 156. In some embodiments, the transition 184 may position the longitudinal dimension of the flange 188 at an angle relative to the housing 128. In some embodiments, the angle between the conduit 116 and the housing 128 may be 90-degrees. In general, however, the value of the angle between the conduit 116 and the housing 128 will depend upon the particular vehicle, as well as the specific configuration of the engine 104, for which the air box 100 is to be utilized. As such, any value of the angle and the offset of the conduit 116 may be incorporated into the air box 100 without detracting from the present disclosure.

The flange 188 comprises an opening 192 that is configured to conduct the airstream 136 from the interior 172 of the air filter 144 to the air intake duct 120. It should be understood that the flange 188 has a configuration and an exterior diameter, and the opening 192 has an inner diameter that are suitable for coupling with the air intake duct 120 of the engine 104. As shown in Figs. 3-4, the exterior diameter of the transition 184 may taper along the length of the conduit 116 to a suitable exterior diameter of the flange 188. Moreover, in some embodiments, the flange 188 may comprise any of various additional ridges, raised portions, or other surface features so as to optimally engage with the air intake duct 120. The specific configuration of the flange 188 and the inner diameter of the opening 192 will depend upon the particular make, model, and engine configuration of the vehicle for which the air box 100 is to be utilized, and thus a wide variety of configurations and diameters may be incorporated into the conduit 116, without limitation.

As best illustrated in Fig. 2, each of the air inlets 124 is configured to be coupled with an air inlet port 112 disposed within the engine bay 108. As mentioned herein, the air inlet ports 112 generally extend through the vehicle to a source of external air, such as a front of the vehicle. Each air inlet 124 comprises an opening having a size, shape, and orientation that substantially match the size, shape, and orientation of the particular air inlet port 112 to which the air inlet 124 is to be coupled. In some embodiments, the air inlets 124 may be configured to be slightly larger than the air inlet ports 112, such that the air inlets 124 may receive the air inlet ports 112 into an interior of the air inlets. In some embodiments, the air inlets 124 may be configured to be substantially the same size and shape as the air inlet ports 112, such that the air inlets 124 may be aligned with, and pressed against the air inlet ports 112. Still, in some embodiments, the air inlets 124 may be configured with a size and shape that is slightly smaller than the size and shape of the air inlet ports 112, such that the air inlets 124 may be inserted into the interior of the air inlet ports 112. It is contemplated that any of various suitable hardware fasteners may be utilized to couple the air inlets 124 with the air inlet ports 112. It is further contemplated that any of various additional bends, ridges, raised portions, or other surface features may be incorporated into the air inlets 124 so as to optimally engage with the air inlet ports 112 of the vehicle. As such, the specific configuration of the air inlets 124 will depend upon the particular make, model, and configuration of the engine 104 of the vehicle for which the air box 100 is to be utilized, without limitation, and without deviating beyond the spirit and scope of the present disclosure.

In the embodiment illustrated in Figs. 1-4, a seal 196 is disposed around a perimeter edge of each of the air inlets 124. The seal 196 serves to establish a substantially air-leak resistant junction between the air inlet port 112 and the air inlet 124. In some embodiments, the seal 196 is comprised of a molded pliable strip that may be pressed onto the perimeter edge of the air inlet 124, as shown in Figs. 3-4. The molded pliable strip may include a recess that is configured to fixedly receive the perimeter edge of the air inlet 124, such that the seal 196 remains fixed to the perimeter of the air inlet. The seal 196 may be comprised of any cross-sectional shape that is suitable for sealing the junction between the air inlet 124 and the air inlet port 112.

In some embodiments, the seal 196 may be comprised of pliable stripping that is configured to be disposed between an interior of the perimeter edge of the air inlet 124 and an exterior of the air inlet port 112. The pliable stripping may be affixed to either the air inlet 124 or the air inlet port 112 by way of a suitable adhesive or any of various fasteners. In some embodiments, wherein the air inlets 124 are configured to be inserted into the air inlet ports 112, the pliable stripping may be affixed between the interior of the air inlet port 112 and the exterior of the air inlet 124.

It should be understood that the number of air inlets 124 comprising the air box 100 is not to be limited to two air inlets, as shown in the illustrated embodiment of Figs. 1-4. Although some vehicles include two air inlet ports 112, as shown herein, other similar vehicles may be limited to solely either one of the two air inlet ports 112. It is contemplated, therefore, that either one of the air inlets 124 may be blocked to the airstream 136, as needed, during installation of the air box 100 into the engine bay 108. Any of various mechanical devices may be used to block either of the air inlets 124, such as, by way of non-limiting example, baffles, valves, caps, slats, panels, and the like. In some embodiments, either one of the air inlets 124 may be omitted from the air box 100, without limitation, so as to accommodate a target vehicle that lacks the corresponding air inlet port 112.

In some embodiments, the housing 128 and the duct 132 may include any of various surface features or contoured portions that are configured to provide clearance with nearby components disposed on the engine 104 or located elsewhere within the engine bay 108. For example, as best shown in Fig. 3, the duct 132 includes a longitudinal groove 200 that is configured to provide clearance for a hood prop (not shown) when the hood of the vehicle is closed. Further, a front support 204 is disposed on the duct 132 forwardly of the air inlets 124. The front support 204 is configured to be received by a mounting portion 208 of the engine bay 108 so as to maintain the air inlets 124 engaged with the air inlet ports 112, as described herein. It should be understood that a wide variety of surface features, contoured portions, and suitable supports may be coupled with the air box 100, without limitation.

It is contemplated that a wide variety of peripheral components may be coupled with the housing 128 and the duct 132, as needed. In some embodiments, for example, one or more sheet metal components may be fastened onto locations of the duct 132 that are near heated components within the engine bay 108, such as an exhaust manifold of the engine 104. In some embodiments, one or more pliable pads may be strategically located on the exterior of the housing 128 and the duct 132 so as to cushion contact with nearby components within the engine bay 108. It is envisioned that the pliable pads may be comprised of rubber suitable to reduce vibrations occurring between the air box 100 and the nearby components. In some embodiments, a latch mechanism may be installed within the longitudinal groove 200 and configured to retain the hood prop when the hood of the vehicle is closed. It should be understood that a wide variety of components or devices may be coupled with the air box 100 so as to facilitate operation of the air box within the engine bay 108 and in connection with the engine 104, without limitation.

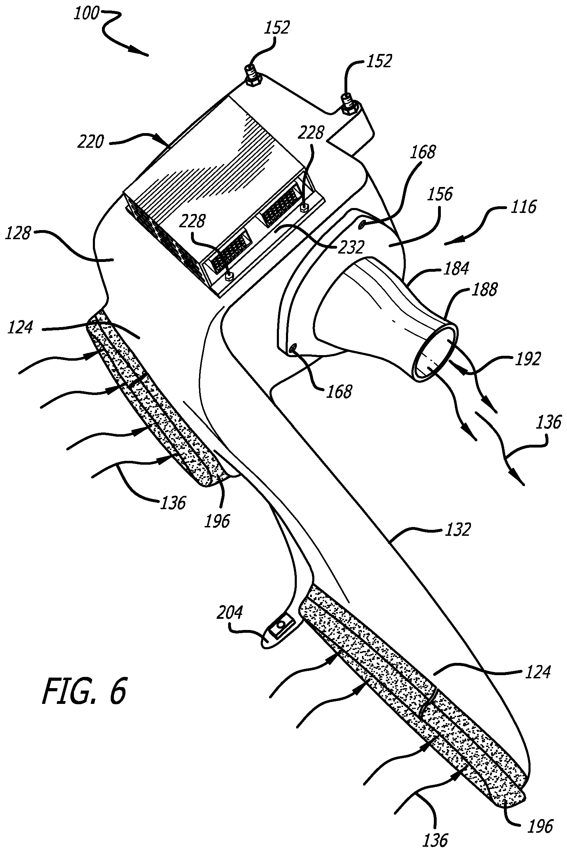

Referring again to Fig. 4, the housing 128 comprises an opening 212 into the interior 140. The opening 212 comprises an edge portion 216 that is configured to be coupled with a flat panel (not shown) so as to enclose the interior 140. In some embodiments, the edge portion 216 may be configured to be coupled with a flat surface of an engine control unit (ECU) 220, such that the ECU 220 encloses the interior 140, as shown in Fig. 6. In such embodiments, the flat surface of the ECU 220 may be placed into direct contact with the airstream 136, such that the airstream transfers heat away from the ECU 220 before being drawn through the air filter 144 and into the air intake duct 120 of the engine 104. As shown in Figs. 4 and 6, a multiplicity of threaded holes 224 may be disposed in suitable locations within the edge portion 216 to threadably receive fasteners 228 positioned in mounting holes of the ECU 220. As will be appreciated, however, any of various fastening means other than the fasteners 228 may be utilized to attach the ECU 220 to the edge portion 216, without limitation.

As more particularly illustrated in Fig. 6, the edge portion 216 generally is configured to receive feet 232 of the ECU 220, such that the flat surface of the ECU 220, between the feet 232, is placed into direct contact with the airstream 136. It is envisioned that the flat surface will advantageously transfer heat away from the electronic components within the ECU 220. In the embodiment illustrated in Fig. 6, the feet 232 are coupled with the edge portion 216, such that the flat surface of the ECU 220 between the feet 232 effectively encloses the interior 140 of the housing 128. A gasket or a seal may be disposed between the flat surface and the edge portion 216 so as to provide an airtight coupling between housing 128 and the ECU 220. Further details about coupling the ECU 220 with the air box 100 so as to cool the ECU are disclosed in U.S. Patent Application Serial No. 16/173,489, entitled "Engine Control Unit Cooling Air Box".

It is contemplated that the opening 212 facilitates installing and removing the air filter 144 from the housing 128, as needed. For example, once the air filter 144 is dirty, the air filter may be removed from the housing and a new, clean air filter 144 may be installed. A transparent portion 236, as shown in Figs. 1-3, may be disposed on a top of the housing 128 to facilitate direct observation of the condition of the air filter 144. In one embodiment, a method for removing the air filter 144 comprises removing the above-mentioned flat panel or the ECU 220 from the edge portion 216 to provide access to the interior 140 of the housing 128. The fasteners 168 may then be loosened to release the base 160 of the air filter 144 from the mount portion 156. Upon removing the fasteners 168, the air filter 144 may be removed from the interior 140 by way of the opening 212.

Although the method for removing the air filter 144 generally facilitates replacing the air filter, when dirty, with a clean air filter, it is contemplated that the method for removing the air filter 144 is particularly advantageous for use with embodiments of the air filter 144 that are configured to be periodically cleaned and reused. For example, in some embodiments, the air filter 144 may be comprised of multiple layers of cotton gauze that are treated with a filter oil composition that enhances the filtration properties of the air filter. It is contemplated that a practitioner may clean the air filter 144 by first removing from the air filter from the housing 128, as described above, and then applying a solvent to remove the filter oil from the filter medium 176. The practitioner may clean the air filter 144 by inserting a water hose through the base 160 and into the interior 172 of the air filter 144 and spraying water so as to flush contaminants from the filter medium 176. Further details about periodic cleaning of the air filter 144, as well as details about the filter oil composition, are disclosed in U.S. Patent Application Serial No. 14/181,678, entitled "Air Box With Integrated Filter Media," filed on February 16, 2014, and U.S. Patent Application Serial No. 14/701,163, entitled "Filter Oil Formulation".

While the invention has been described in terms of particular variations and illustrative figures, those of ordinary skill in the art will recognize that the invention is not limited to the variations or figures described. In addition, where methods and steps described above indicate certain events occurring in certain order, those of ordinary skill in the art will recognize that the ordering of certain steps may be modified and that such modifications are in accordance with the variations of the invention. Additionally, certain of the steps may be performed concurrently in a parallel process when possible, as well as performed sequentially as described above. To the extent there are variations of the invention, which are within the scpoe of the invention as defined by the claims, it is the intent that this patent will cover those variations as well. Therefore, the present disclosure is to be understood as not limited by the specific embodiments described herein, but only by the scope of the appended claims.

## Claims

1. An air box configured to communicate an airstream (136) from one or more air inlet ports (112) through an air filter (144) to an air intake duct of an engine, comprising:
a housing (128) configured to support the air filter within an interior of the housing;
one or more air inlets (124) that are configured to receive the airstream from the one or more air inlet ports;
a duct (132) configured to direct the airstream from the one or more air inlets to the interior of the housing;
an opening into the housing that is configured to expose at least one surface of an electronic control unit, ECU (220), to the airstream; and
a conduit (116) configured to communicate the airstream from an interior of the air filter to the air intake duct.

2. The air box of claim 1, wherein a multiplicity of protrusions are disposed on the housing and configured to facilitate fixedly coupling the air box with the engine, the multiplicity of protrusions being configured to cooperate with any of various mounts and pads disposed within the engine bay.

3. The air box of claim 1 or 2, wherein one or more surface features are disposed on any of the housing and the duct.

4. The air box of claim 3, wherein the one or more surface features are comprised of a groove (200) disposed longitudinally along the duct and configured to receive a hood prop of a vehicle in which the air box is installed.

5. The air box of claim 3, wherein the one or more surface features are comprised of contoured portions that are configured to provide clearance between the air box and nearby components disposed on the engine.

6. The air box of any preceding claim, wherein the one or more air inlets are configured to be blocked to the airstream so as to facilitate operation of the air box in absence of either of the one or more air inlet ports.

7. The air box of any preceding claim, wherein each of the one or more air inlets comprises an opening that is configured to be coupled with a corresponding one of the one or more air inlet ports, such that the airstream is passed through the one or more air inlets and into the duct.

8. The air box of any preceding claim, wherein a seal is disposed around a perimeter edge of each of the one or more air inlets and configured to establish a substantially air-leak resistant junction between the one or more air inlets and the one or more air inlet ports.

9. The air box of any preceding claim, wherein the housing is comprised of a flat surface that is configured to receive a base of the air filter, the base being comprised of a seal that is configured to be compressed so as to establish an air-leak resistant connection between the base and the flat surface.

10. The air box of claim 9, wherein the flat surface comprises a mount portion (156) of the housing that is configured to facilitate using one or more suitable fasteners to compress the seal between the flat surface and the base.

11. The air box of any preceding claim, wherein the opening comprises an edge portion (216) that is configured with one or more threaded holes disposed in suitable locations to receive one or more fasteners to fixedly attach the ECU to the housing, such that the at least one surface effectively encloses the interior of the housing.

12. A method for an air box to communicate an airstream from one or more air inlet ports to an air intake duct of an engine, comprising:
supporting an air filter within an interior of a housing;
configuring one or more air inlets to receive the airstream from the one or more air inlet ports;
coupling the one or more air inlets with a duct to direct the airstream from the one or more inlets to the air filter;
forming an opening in the housing to expose at least one surface of an electronic control unit (ECU) to the airstream; and
extending a conduit from an interior of the air filter to the air intake duct.

13. The method of claim 12, wherein supporting comprises configuring a flat surface within the housing to receive a base of the air filter, the base being comprised of a seal that is configured to be compressed so as to establish an air-leak resistant connection between the base and the flat surface.

14. The method of claim 12 or 13, wherein configuring the one or more air inlets comprises configuring a seal around a perimeter edge of each of the one or more air inlets to establish a substantially air-leak resistant junction between the one or more air inlets and the one or more air inlet ports.

15. The method of claim 12, 13 or 14, wherein forming an opening further comprises configuring an edge portion of the opening to receive one or more fasteners to fixedly attach the ECU to the housing.
